# EUROPEAN PATENT APPLICATION

(11) **EP 4 425 562 A2**
(43) Date of publication of application: **04.09.2024**
(21) Application number: 24159349.0
(22) Date of filing: 23.02.2024
(51) Int. Cl.: H01L 29/04, H01L 29/08, H01L 29/78, H01L 21/04, H01L 21/336

(54) **PROCESS FOR MANUFACTURING A POWER ELECTRONIC DEVICE HAVING A CURRENT SPREADING LAYER**

(30) Priority: 03.03.2023 IT 202300003897
(71) Applicant: STMicroelectronics International N.V., 1228 Plan-les-Ouates, Geneva (CH)
(72) Inventor: GUARNERA, Alfio, 95039 TRECASTAGNI (CT) (IT); CAMALLERI, Cateno Marco, 95125 CATANIA (IT); ZANETTI, Edoardo, 95028 VALVERDE (CT) (IT); SCALIA, Laura Letizia, 95037 SAN GIOVANNI LA PUNTA (CT) (IT); BERTOLINI, Mario Pietro, 97018 SCICLI (RG) (IT); CANTIANO, Massimiliano, 95127 CATANIA (IT); BOSCAGLIA, Massimo, 95037 SAN GIOVANNI LA PUNTA (CT) (IT); SAGGIO, Mario Giuseppe, 95020 ACI BONACCORSI (CT) (IT)
(74) Representative: Studio Torta S.p.A.

(57) **Abstract**

A process for manufacturing a power electronic device (100), envisages: forming a semiconductor body (4) of silicon carbide, having a first electrical conductivity (n) and a first doping value, and defining a front surface (1a); forming a Current Spreading Layer, CSL, (6) in a surface portion of said semiconductor body (4) facing the front surface (1a), having the first electrical conductivity (n) and a second doping value, greater than the first doping value; forming elementary cells of the power electronic device (100) in an active area of the semiconductor body (4) at the front surface (1a). The step of forming the current spreading layer (6) envisages performing a channeled ion implantation, in a channeling condition, for implanting doping ions having the first electrical conductivity (n) within the semiconductor body (4).

## Description

### TECHNICAL FIELD

The present solution relates to a process for manufacturing a power electronic device, having a current spreading layer, CSL; in particular, the following discussion will make particular reference to a power electronic device formed starting from a silicon-carbide, SiC, substrate.

### BACKGROUND

As it is known, semiconductor materials having a wide bandgap, for example greater than 1.1 eV, low on-state resistance, high thermal conductivity, high operating frequency and high saturation velocity of the charge carriers allow manufacturing of electronic devices, for example diodes and transistors, which may have better performances than silicon electronic devices, in particular for power applications, for example with operating voltages comprised between 600 V and 1300 V and/or specific operating conditions such as high temperature.

In particular, these power electronic devices may advantageously be formed starting from a wafer of silicon carbide, a material which has the characteristics listed above, in one of its polytypes, for example 3C-SiC, 4H-SiC and 6H-SiC.

In a known manner, power electronic devices may include a current spreading layer, CSL, having a suitable doping, in order to locally modulate the resistivity of the silicon-carbide substrate, causing the injected current to spread in a uniform manner across an area of the same substrate. For example, in a MOSFET power transistor device, the CSL layer may be used in the intercell (or JFET) region to reduce the on-state resistance (Rₒₙ).

The process for manufacturing such power electronic devices therefore comprises, typically in an initial step, formation of the current spreading layer by a dedicated epitaxial growth, performed starting from the substrate, for example of silicon carbide.

In particular, in order to obtain a desired resistance value, the formation of a thick epitaxial layer is required, so that, typically, at least two epitaxial growths are required to reach the desired thickness.

This manufacturing process entails times and costs which are quite high, due to the need to implement the control of the process recipe and parameters to implement a second epitaxial growth, independently of, and in addition to, a first epitaxial growth.

As an alternative to epitaxial growth, the implementation of a traditional ion implant has been proposed for forming the current spreading layer, this implant being performed at high energy and high temperature.

However, this solution is particularly complex, given that numerous implant steps are typically required for forming a uniform doping profile layer (in this regard, it is highlighted that the diffusion of the dopants is not an applicable technique due to the low diffusivity in silicon carbide compared to other semiconductor materials, such as silicon).

### SUMMARY

The present solution has the aim of solving, at least in part, the previously highlighted issues, providing an alternative process for manufacturing of the current spreading layer in a power electronic device, in particular of silicon carbide, which offers a simpler and cheaper implementation.

According to the present solution, a manufacturing process is therefore provided, as defined in the attached claims.

### BRIEF DESCRIPTION OF THE FIGURES

For a better understanding of the present invention, a preferred embodiment thereof is now described, purely by way of non-limiting example and with reference to the attached drawings, wherein:
- Figures 1A-1D are cross-sections of a semiconductor material wafer, in successive steps of a process for manufacturing a power electronic device, according to a first embodiment of the present solution;
- Figure 2 shows plots of doping profiles, which may be implemented in a current spreading layer in the power electronic device; and
- Figures 3A-3C are cross-sections of a semiconductor material wafer, in successive steps of a process for manufacturing a power electronic device, in accordance with a second embodiment of the present solution.

### DESCRIPTION OF EMBODIMENTS

As will be described in detail below, one aspect of the present solution envisages formation of a current spreading layer (CSL layer) in a power electronic device, in particular made of silicon carbide, by a channeled ion implantation process (in a so-called "channeling" condition).

In a known manner, the channeling condition occurs when the direction of the implanted ion beam is oriented along one of the semiconductor material crystallographic axes, substantially parallel thereto.

When implanted in the crystal lattice, the ions generally tend to disperse due to impacts with the atoms of the crystal lattice (according to the phenomenon of impact scattering).

When the implant direction is oriented to an oblique angle with respect to the main axes of the crystal lattice, the atoms in the lattice have a random distribution with respect to the implant direction; the probability of collisions between the implanted ions and the atoms of the crystal lattice is therefore substantially uniform as the depth varies. Therefore, in this implant condition, doping profiles, which are substantially Gaussian with respect to the depth, are obtained, where the depth reached by the implant is determined by the energy, the ions used and the atomic structure of the target.

If the implant direction is instead a channeling direction, close to a main axis of the crystal lattice, the atoms in the crystal lattice define "channels" that may be traversed by the implanted ions. This reduces the probability of collisions between the implanted ions and the atoms of the crystal lattice, especially near the surface of the wafer wherein the implant occurs, resulting in that the depth of the same implant may be significantly increased.

In general, the implant channeling occurs when the implant direction is within a critical angle with respect to the channeling direction. In this configuration, the loss of electron energy (interaction with the electron clouds of the crystal atoms) is prevalent with respect to the nuclear loss (impacts with the crystal nuclei). The value of the critical angle depends for example on the direction, the species and the energy used.

As used herein, the term "implant angle" refers to the tilt angle of the wafer during the implant. It may be defined in general as angle with respect to the surface of the wafer. In general, the surface of the wafer is not a crystallographic plane, as it is defined by a cut angle suitable for subsequent epitaxial processes, for example 4°; in the example, therefore, to identify the <0001> direction of the crystal lattice during the implant, the wafer needs to be tilted with a tilt angle of 4°.

Channeling is typically an undesired effect during manufacturing of power electronic devices (for example, because the implant depth may be greater than the desired depth and because it is difficult to control the value of the same depth) and the implant direction is therefore generally oriented in a non-channeling direction, to minimize channeling effects.

As previously indicated, the present Applicant has however realized the possibility of providing, in a controlled and repeatable manner, channeled implants within the process for manufacturing a silicon-carbide power electronic device, in particular for forming a corresponding current spreading layer.

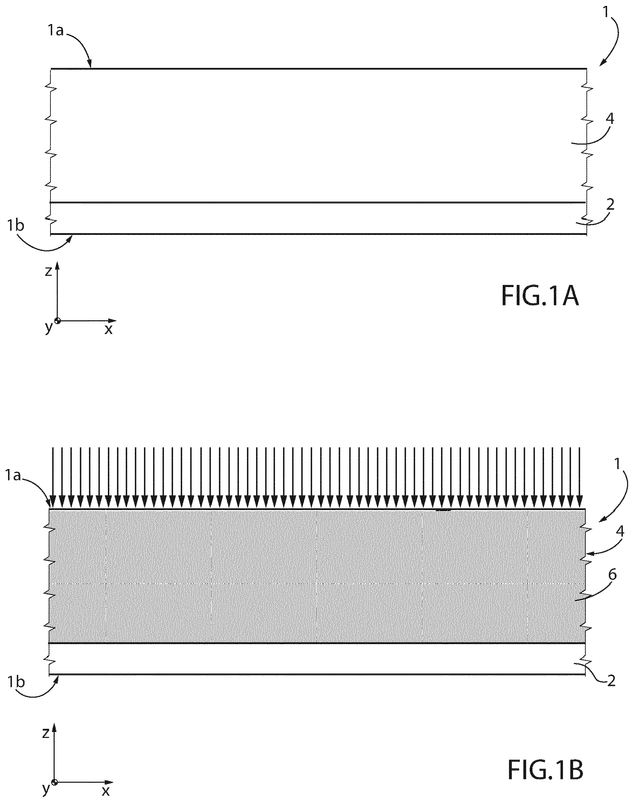

With reference first to Figure 1A, a first embodiment of the present solution initially envisages the provision of a wafer 1 comprising a substrate 2 of silicon carbide, for example of 4H-SiC-type having a doping with n-type conductivity (for example with a dose of the order of 5e¹⁸ ions cm⁻³), and delimited by a front surface 1a and a rear surface 1b, having a main extension in a horizontal plane xy and opposite to each other along a vertical axis z, orthogonal to the horizontal plane xy.

As shown schematically in the same Figure 1A, an epitaxial growth is then performed for forming a drift layer 4 on the substrate 2, also having a n-type conductivity, for example n⁻ (with a dose of the order of 5e¹⁵ ions cm⁻³); this drift layer 4 therefore defines the front surface 1a of the wafer 1.

In particular, following the epitaxial growth, the silicon carbide crystallographic lattice is oriented at a certain angle (non-zero) with respect to the surface of the wafer 1. In a possible implementation, the 4H-SiC lattice structure has an off-cut angle of about 4° (intended as the angle between the surface of the wafer 1 and the main crystallographic plane, for example along the <0001> direction).

According to one aspect of the present solution, as shown in Figure 1B, a blank implant is then performed in the active area in channeling condition for forming a current spreading layer (CSL) 6, continuous and seamless, in proximity of the front surface 1a of the wafer 1, having n-type conductivity and greater doping than that of the drift layer 4 (thus operating as an enrichment layer).

In particular, the implant is performed at a certain angle (tilt angle) with respect to a direction orthogonal to the front surface 1a of the wafer 1, in such a way as to provide the channeling conditions and thus allow the channeling of the implanted ions towards the depth of the drift layer 4.

In the previously discussed implementation (with the 4H-SiC lattice and considering that the implant is performed with phosphorus, P, atoms with an implant energy for example equal to 240 keV), the ion implant may be performed with a tilt angle comprised between 3.5° and 4.5°, for example equal to about 4°, in such a way that the implantation occurs substantially in a channeled manner along the <0001> direction of the crystal lattice.

The implant dose may be for example of about 8·10¹² ions cm⁻² (nominal) and the implantation may be performed at room temperature.

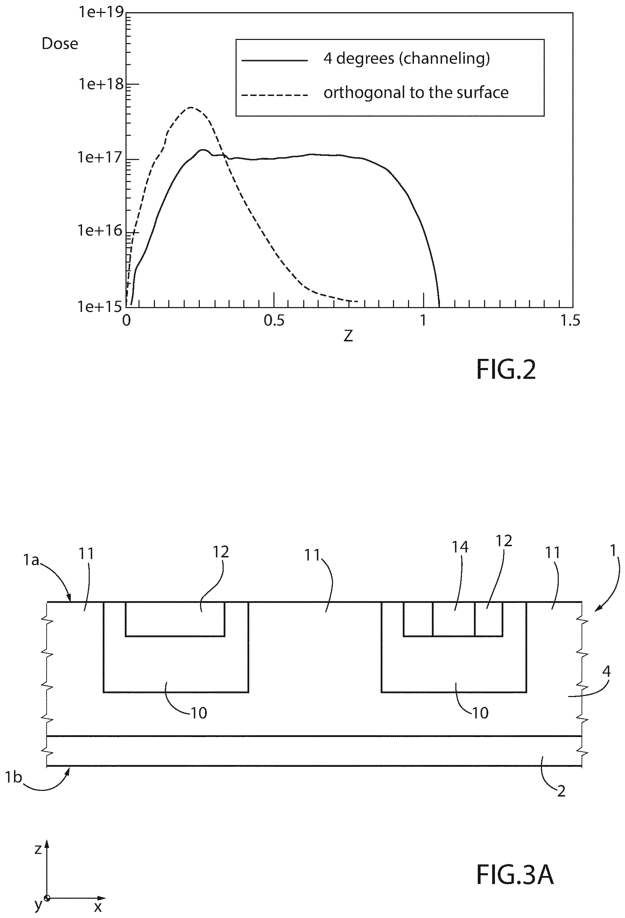

Figure 2 shows the implant profile (i.e. the implant dose as a function of the depth in the drift layer 4 along the vertical axis z) in two different conditions: with an implantation performed in channeling condition, in the example with tilt angle equal to 4° (profile shown in solid line); and with an implantation with a direction orthogonal to the surface, with a substantially zero tilt angle (profile shown in dashed line).

It is evident that the channeled implant allows a substantially flat doping profile to be obtained, within a desired depth of the current spreading layer 6 starting from the front surface 1a of the wafer 1 (this depth being for example comprised between 0.5 and 5 µm, for example equal to 2 µm).

In greater detail, the present Applicant has experimentally demonstrated that the discussed channeled ion implantation allows a very precise control of the doping of the current spreading layer 6, in particular with variations lower than 1% with respect to a desired value (in this regard, in case of epitaxial manufacturing of the same current spreading layer, typical doping variations of the order of 10% are obtained).

This allows for improved performances of the resulting power electronic device in terms of on-state resistance (Rₒₙ), breakdown voltage (BV) and drain-source leakage current IDSS.

Furthermore, the aforementioned channeled ion implantation allows very precise control of the depth of the current spreading layer 6, in particular with variations lower than 1% with respect to a desired value (in this regard, in case of epitaxial manufacturing of the same current spreading layer typical depth variations of the order of 10% are obtained).

This again allows for improved performances of the resulting power electronic device in terms of breakdown voltage (BV) and drain-source leakage current IDSS and also brings benefits in capacitance control.

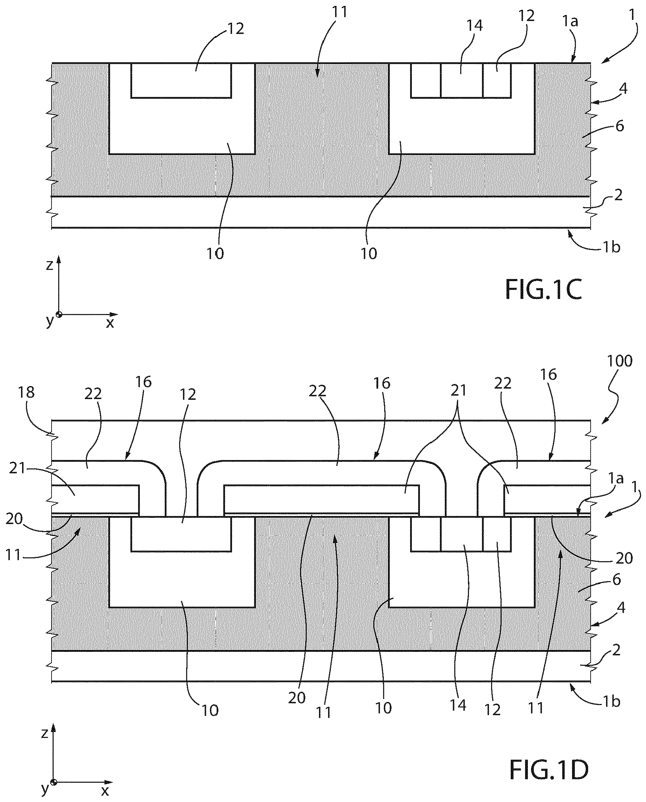

With reference to Figure 1C, the manufacturing process then proceeds with the formation, in the active area, of elementary cells of the power electronic device.

Body regions 10 are then initially formed within the drift layer 4 and in particular within the current spreading layer 6, that was previously formed, at the front surface 1a of the wafer 1, by a masked implantation of p-type doping ions (this implantation being performed in a traditional manner, i.e. with a random ion implant, with a substantially zero tilt angle).

The body regions 10 are separated at a certain distance from each other along a x axis of the horizontal plane xy; in particular, the portions of the drift layer 4 between adjacent body regions 10, at the front surface 1a, are defined as intercell or JFET regions and are indicated by 11.

Subsequently, as shown in the same Figure 1C, respective source regions 12 are formed, again by masked ion implantation, in this case of n-type (for example with nitrogen or phosphorus ions), within each body region 10 (centrally with respect thereto). These source regions 12 have a depth along the vertical axis z smaller than a corresponding depth of the same body regions 10.

After the implant, the wafer 1 may be subjected to annealing for activating the doping ions and for reducing the defects in the crystal lattice.

Thus, as shown in the same Figure 1C, body contact regions 14 are formed within some of the source regions 12 (centrally with respect thereto) and at the front surface 1a of the wafer 1. In particular, as shown in the aforementioned Figure 1C, a body contact region 14 may be formed every two source regions 12.

These body contact regions 14, which have the purpose of creating an ohmic contact with the respective body regions 10, are formed again by masked ion implant, in this case of p⁺ type with a high doping dose (for example comprised between 10¹⁴ and 5·10¹⁵ ions cm⁻²), and suitable energy (for example comprised between 10 keV and 300 keV).

After a possible annealing step and the removal of the previously used masks, the wafer 1 is processed in a known manner, forming insulated gate structures 16 on the front surface 1a of the wafer 1 and a source metallization region 18.

In particular, these insulated gate regions 16 are each formed by: a gate insulating region 20, for example of oxide, in contact with the front surface 1a of the wafer 1, above the aforementioned JFET region 11; a gate conductive region 21, directly superimposed on the gate insulating region 20, of a conductive material; and a passivation region 22, covering the gate conductive region 21 and sealing, together with the gate insulating region 20, the gate conductive region 21.

The gate conductive regions 21 of the insulated gate structures 16 are electrically connected in parallel, in a manner not shown here, forming a gate terminal of the MOSFET power electronic device.

The source metallization region 18, for example of metal material and/or metal silicide, forms a source terminal of the MOSFET power electronic device and extends over the first surface 1a of the wafer and over the insulated gate structures 16, in direct electrical contact with the source regions 12 and the body contact regions 14.

In a manner not illustrated, a further metallization region may be formed on the rear surface 1b of the wafer 1, to form a drain terminal of the same power electronic device.

Each elementary cell of the MOSFET power electronic device, which is indicated as a whole in Figure 1D by 100, is therefore formed by an insulated gate structure 16 and by the adjacent portions of the body 10 and source 12 regions, as well as by the underlying JFET region 11.

A second embodiment of the present solution is now described, which differs from what has been previously described, due to a different formation of the current spreading layer, which is again denoted by 6, which in this case is not continuous in the active area (as in the first embodiment), but comprises a plurality of distinct portions, which are denoted by 6'.

In particular, these distinct portions 6' extend only at, and in a localized manner with respect to, the JFET regions 11 of the elementary cells of the MOSFET power electronic device; the same distinct portions 6' of the current spreading layer 6 do not extend in this case in the portions of the drift layer 4 below the source regions 12 (and the body regions 10) of the elementary cells.

In detail and with reference first to Figure 3A, the manufacturing process in this case envisages, after formation of the drift layer 4 (as previously discussed), the formation the body regions 10 in the same drift layer 4, at the front surface 1a of the wafer 1.

Then, again as previously discussed, the source regions 12 are formed within the body regions 10 and, in the example illustrated, the body contact regions 14 within some of the source regions 12.

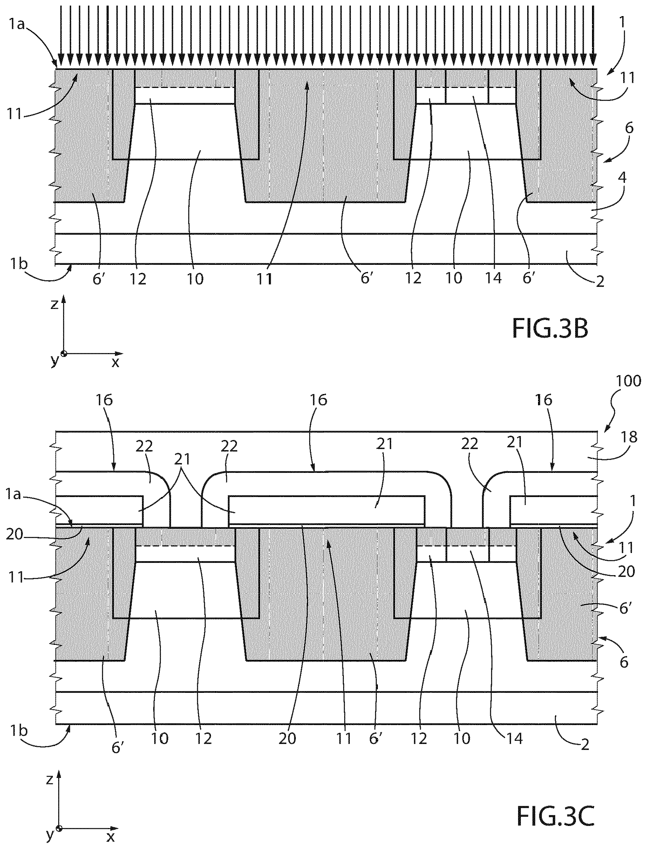

In this second embodiment, as shown in Figure 3B, only at this point the ion implantation is carried out in channeling condition (for example, as previously discussed with a tilt of 4° and at room temperature) for the formation of the current spreading layer 6, and in particular of the corresponding distinct portions 6' which extend at, and in a localized manner with respect to, the JFET regions 11.

The source regions 12 (and the body contact regions 14) are in fact surface regions heavily damaged from the point of view of the crystal lattice, having been subject to previous doping by ion implantation (performed in a traditional manner, i.e. with a substantially zero tilt angle). The crystal lattice at these heavily damaged regions therefore represents a barrier to the implanted ions, which distribute randomly without penetrating in depth.

As a result, the ion implantation in channeling condition is performed in a self-aligned manner with respect to these source regions 12, so that the implanted ions proceed along a depth direction, due to the channeling condition, only at the JFET regions 11, for forming the aforementioned distinct portions 6' of the CSL layer 6 (having, at the end of the implantation, a greater depth than the body regions 10).

Substantially, in the damaged regions, the implantation produces a profile with a very small depth and a substantially negligible random implant peak, such as not to alter (or in any case so as to modify in a limited and controllable manner) doping of the source regions 12 (and, if any, of the body contact regions 14). Conversely, where the same damaged regions (which act as an implant mask) are not present, a flat implant profile is generated in the depth direction in the drift layer 4, in a manner completely analogous to what has been previously discussed with reference to Figure 2 (with the difference that, in this case, this doping profile is localized to the sole JFET regions 11).

The depth of the ion implantation is therefore modulated in a self-aligned manner with respect to the aforementioned source regions 12, without resorting to the use of implant masks.

Advantageously, in this second embodiment, the distinct portions 6' of the CSL layer 6 allow the resistivity of the JFET regions 11 to be reduced in a desired manner, while not varying the characteristics of the portions of the drift layer 4 underlying the source regions 12, in particular, without increasing the doping thereof and without varying the characteristics of the body/drain junctions.

The manufacturing process, as shown in Figure 3C, subsequently proceeds, in a manner similar to what has been previously discussed, by forming the insulated gate structures 16 on the front surface 1a of the wafer 1 and the source metallization region 18 of the resulting power electronic device 100.

The advantages of the proposed solution are clear from the previous description.

In any case, it is underlined that forming the current spreading layer by a single channeled ion implantation step allows the yield to be improved and the costs of the manufacturing process to be reduced (avoiding the repetition of epitaxial growth steps), while improving the electrical characteristics of the resulting power electronic device.

Furthermore, carrying out the channeled ion implantation in a manner self-aligned to the source regions formed prior to the same implantation allows the desired effect of reducing the resistivity of the JFET regions to be obtained, without however degrading the characteristics of the body/drain junction.

Finally, it is clear that modifications and variations may be made to what is described and illustrated herein without thereby departing from the scope of the present invention, as defined in the attached claims.

In particular, it is highlighted that the described solution may also find advantageous application in different power electronic devices, for example in diodes or JFET transistors.

The channeled ion implantation may be performed with different doping ions, for example with nitrogen atoms (instead of phosphorus atoms). However, using phosphorus has proven to be particularly advantageous due to the resulting flat doping profile of the current spreading layer.

Furthermore, the semiconductor material wafer may be made of a material other than SiC, such as for example GaN.

## Claims

1. A process for manufacturing a power electronic device (100), comprising:
- forming a semiconductor body (4) of silicon carbide, having a first electrical conductivity (n) and a first doping value and defining a front surface (1a);
- forming a Current Spreading Layer, CLS, (6) at a surface portion of said semiconductor body (4) facing the front surface (1a), said current spreading layer (6) having the first electrical conductivity (n) and a second doping value, greater than the first doping value;
- forming elementary cells of said power electronic device (100) in an active area of said semiconductor body (4) at said front surface (1a),
**characterized in that** forming the current spreading layer (6) comprises performing a channeled ion implantation, in a channeling condition, for implanting doping ions having said first electrical conductivity (n) within said semiconductor body (4).

2. The process according to claim 1, wherein said doping ions are phosphorus atoms.

3. The process according to claim 1 or 2, wherein said channeled ion implantation is performed along an implantation direction tilted by a non-zero tilt angle with respect to said front surface (1a).

4. The process according to claim 3, wherein said tilt angle is comprised between 3.5° and 4.5°, such that said channeled ion implantation is directed along a main axis of the silicon carbide crystallographic lattice of said semiconductor body (4) and the doping ions penetrate within said semiconductor body (4).

5. The process according to any of the preceding claims, wherein said channeled ion implantation has a substantially flat implant profile along a vertical axis (z) orthogonal to said front surface (1a) in a depth direction of said current spreading layer (6).

6. The process according to any of the preceding claims, wherein said channeled ion implantation is performed in said active area prior to the step of forming said elementary cells; and wherein said current spreading layer (6) is continuous and seamless in said active area.

7. The process according to claim 6, wherein forming said elementary cells comprises:
forming first doped regions (12) at said front surface (1a) within said current spreading layer (6), having said first conductivity type (n), separated from each other in a direction (x) parallel to said front surface (1a) by intercell regions (11) of said power electronic device (100);
wherein said current spreading layer (6) is configured to locally modulate the resistivity of said intercell regions (11) .

8. The process according to any of claims 1-5, wherein forming said elementary cells comprises:
forming first doped regions (12) at said front surface (1a), having said first conductivity type (n), separated from each other in a direction (x) parallel to said front surface (1a) by intercell regions (11) of said power electronic device (100);
and wherein said channeled ion implantation is performed in a self-aligned manner with respect to said first doped regions (12).

9. The process according to claim 8, wherein said first doped regions (12) are damaged regions of the silicon carbide crystallographic lattice, such as to block a propagation of said channeled ion implantation along a vertical axis (z) orthogonal to said front surface (1a) in a depth direction of said semiconductor body (4).

10. The process according to claim 9, wherein said channeled ion implantation has an implant profile with small depth and substantially negligible implant peak at said first doped regions (12).

11. The process according to any of claims 8-10, wherein said current spreading layer (6) comprises a plurality of distinct portions (6') localized at said intercell regions (11) and configured to locally modulate the resistivity of said intercell regions (11); and wherein said distinct portions (6') of the current spreading layer (6) do not extend into said semiconductor body (4) below said first doped regions (12).

12. The process according to any of claims 8-11, comprising forming second doped regions (14) within at least some of said first doped regions (12), having a second electrical conductivity (p), opposite to said first electrical conductivity (n), prior to performing said channeled ion implantation.

13. The process according to any of the preceding claims, comprising:
providing a wafer (1) comprising a substrate (2);
and wherein forming a semiconductor body (4) comprises performing an epitaxial growth above said substrate (2) to form said semiconductor body (4).

14. The process according to any of the preceding claims, wherein said semiconductor body (4) is of 4H-SiC polytype with an off-cut angle of 4°.

15. The process according to any of the preceding claims, wherein said power electronic device (100) is a MOSFET transistor.
